Europäisches Patentamt

European Patent Office

Office européen des brevets

(19)

(11) Veröffentlichungsnummer: **0 091 106**

**A1**

(12) # EUROPÄISCHE PATENTANMELDUNG

(21) Anmeldenummer: **83103239.6**

(22) Anmeldetag: **31.03.83**

(51) Int. Cl.³: **G 03 B 41/00**

(30) Priorität: **02.04.82 DE 3212393**

(43) Veröffentlichungstag der Anmeldung:
**12.10.83 Patentblatt 83/41**

(84) Benannte Vertragsstaaten:
**AT BE CH DE FR GB IT LI LU NL SE**

(71) Anmelder: **Karl Süss KG Präzisionsgeräte für
Wissenschaft und Industrie - GmbH & Co.
Schleissheimer Strasse 90
D-8046 Garching(DE)**

(72) Erfinder: **Cullmann, Elmar, Dr.
Gärtnerstrasse 12
D-8031 Gröbenzell(DE)**

(72) Erfinder: **Gorgon, Georg
Primelstrasse 12
D-8039 Puchheim(DE)**

(74) Vertreter: **Vossius Vossius Tauchner Heunemann Rauh
Siebertstrasse 4 P.O. Box 86 07 67
D-8000 München 86(DE)**

(54) **Verfahren zum Unterdrücken unerwünschter Beugungs- und/oder Interferenzerscheinungen sowie Ausrichtverfahren und -vorrichtung.**

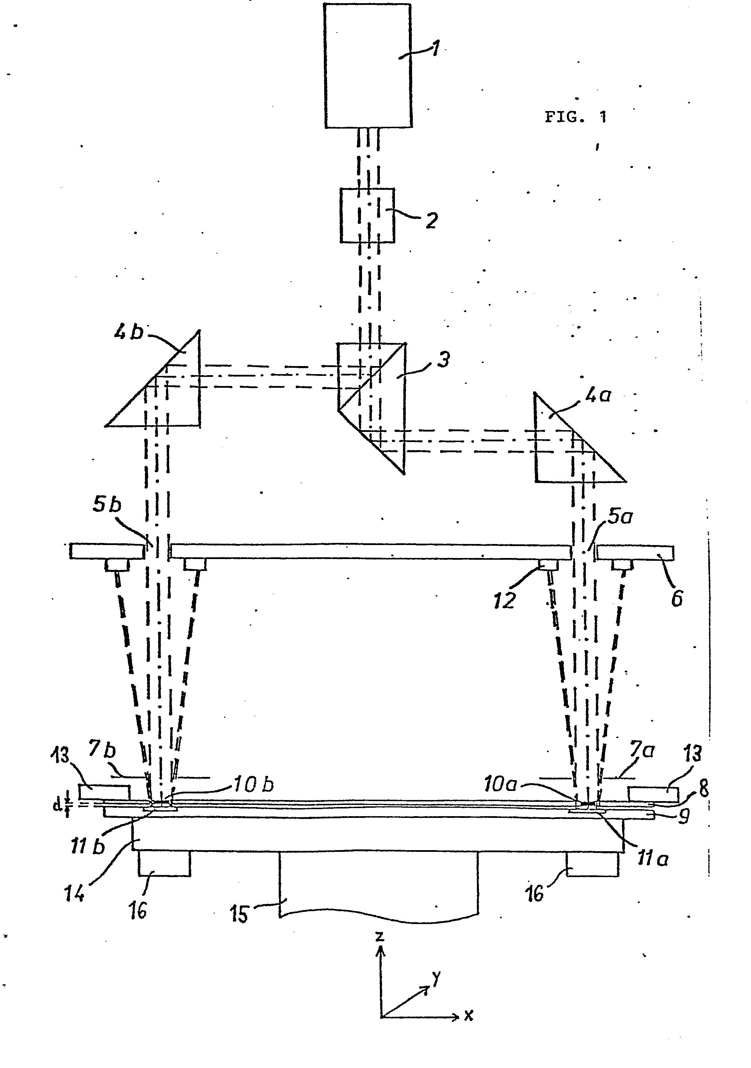

(57) Die Erfindung betrifft ein Verfahren, mit dem störende Interferenzerscheinungen in optischen Systemen unterdrückt werden können. Derartige Erscheinungen treten dann auf, wenn zwei benachbarte Bauteile, beispielsweise eine Maske (8) und ein Substrat (9) einer Ausrichtvorrichtung, von monochromatischer Strahlung getroffen werden und gebeugte oder gebrochene Strahlung interferiert. Dem Verfahren liegt das Prinzip zugrunde, die Maske (8) und das Substrat (9) relativ zueinander derart zu bewegen, daß das Interferenzmuster am Ort der Detektoranordnung (12) räumlich und/oder im zeitlichen Mittel "verschmiert" wird und lediglich einen nicht störenden Untergrund bildet. Weiter ist ein Verfahren und beschrieben eine Vorrichtung zum Ausrichten einer Maske (8) und eines Substrates (9) mit Einrichtungen (13 bis 16) zur Durchführung einer schnellen, periodischen Relativbewegung des Substrates (9) bezüglich der Maske (8) (Fig. 1).

EP 0 091 106 A1

./...

FIG. 1

PATENTANWÄLTE

SIEBERTSTRASSE 4 · 8000 MÜNCHEN 86 · PHONE: (089) 47 40 75
CABLE: BENZOLPATENT MÜNCHEN · TELEX 5-29 453 VOPAT D

**0091106**

— 1 —

u. Z.: S 368 EP (He/vi)
Karl Süss KG, Präzisionsgeräte          31. März 1983
für Wissenschaft und Industrie
– GmbH & Co.
Garching, Bundesrepublik Deutschland

"Verfahren zum Unterdrücken unerwünschter Beugungs- und/oder Interferenzerscheinungen sowie Ausrichtver- fahren und -vorrichtung"

Die Erfindung betrifft ein Verfahren, mit dem das Auftreten unerwünschter Beugungs- und/oder Interferenzerscheinungen in Systemen, insbesondere optischen Systemen, mit mehreren, auftreffende Strahlung beugenden und/oder brechenden Bauteilen verhindert werden kann. Insbesondere betrifft die Erfindung die Anwendung eines derartigen Verfahrens beim gegenseitigen Ausrichten mehrerer Bauteile, wie einer Maske und eines Substrates, wie es insbesondere bei der Herstellung integrierter Schaltungen erforderlich ist, sowie eine Vorrichtung zum Ausrichten mehrerer Bauteile, wie einer Maske und eines Substrates, mit der erfindungsgemäß das Auftreten unerwünschter Beugungs- und/oder Interferenzerscheinungen während des vorzugsweise automatisch erfolgenden Ausrichtvorganges verhindert werden kann.

Unerwünschte Beugungs- und/oder Interferenzerscheinungen können in nahezu allen Systemen auftreten, in denen mehrere, auftreffende Strahlung beugende und/oder brechende Bauteile, wie plane Flächen, in kleinem Abstand, insbesondere in einem Abstand in der Größenordnung der Wellenlänge der auftreffenden Strahlung, voneinander angeordnet sind oder aufeinander abgebildet werden. Wenn auf derartige Bauteile im wesentlichen monochromatische und/oder kohärente Strahlung, wie Laserstrahlung, auftrifft, kann es zu unerwünschter Interferenz der reflektierten und/oder gebeugten Strahlung

0091106

kommen; diese Interferenz ist insbesondere dann störend, wenn die Intensität / erwünschter Strahlung an einem Ort des Systems, an dem die Interferenzerscheinungen auftreten, gemessen wird, und die gemessene Intensität beispielsweise als Regelgröße zu einem Steuerungs- oder Regelvorgang herangezogen wird. Aufgrund der durch die unerwünschte Interferenz hervorgerufenen räumlichen und/oder zeitlichen Intensitätsschwankungen kann es zu Fehlmessungen kommen,wenn beispielsweise ein Extremwert der Intensität der ungestörten (erwünschten) Strahlung ermittelt werden soll, und als Folge einer derartigen Fehlmessung wird der Steuerungs- oder Regelvorgang gestört.

Derartige Probleme treten vor allem in optischen Systemen auf, wie Spektrographen, optischen Abbildungssystemen oder optisch arbeitenden Justiervorrichtungen. Sie treten jedoch nicht nur im Bereich des sichtbaren Lichtes auf, sondern im gesamten Bereich der elektromagnetischen Strahlung, wie im Ultrarot, im Ultraviolett und im Gebiet der Röntgenstrahlung. Ähnliche Probleme sind auch bei der Verwendung von Korpuskularstrahlung, wie Elektronenstrahlung, denkbar. Unter "optischen" Systemen sollen deshalb im folgenden alle Systeme verstanden werden, in denen die vorstehende, insbesondere auf der Wellennatur der verwendeten Strahlung basierende Problematik auftreten kann.

Das vorstehend erläuterte Problem tritt insbesondere auch bei Vorrichtungen und Verfahren zum automatischen Ausrichten (auto alignment) einer Maske bezüglich eines Substrates auf, wie sie bei der Herstellung integrierter Schaltungen (IC's) auf einem Halbleitersubstrat mittels verschiedener Lithographieverfahren, wie lichtoptischer, elektronenoptischer, ionenoptischer und röntgenlithographischer Verfahren, verwendet werden. Derartige Vorrichtungen und Verfahren werden im folgenden allgemein als "optische" Verfahren bzw. Systeme bezeichnet. Beim automatischen Ausrichten von Maske und Substrat werden zumeist Markierungen oder Muster auf der Maske und dem Substrat auf optischem Wege miteinander ausgerichtet bzw. zur Deckung gebracht, wobei mindestens ein von Detektoren registriertes optisches Signal als Meßgröße herangezogen wird, die mittels eines rückgekoppelten Regelkreises mit Stellvorrichtungen für die Maske und/oder das Substrat auf einen vorgegebenen oder während des Regelvorganges zu bestimmenden Sollwert eingeregelt wird; dieser Sollwert zeigt die optimale Ausrichtung von Maske und Substrat an.

Während des Ausrichtens von Maske und Substrat und/oder während der Belichtung des Substrates sind die Maske und das Substrat in einer eng benachbarten, vorzugsweisen planparallelen Stellung angeordnet. Wenn nun die Maske und das Substrat mit elektromagnetischer Strahlung, wie Licht- oder Röntgenstrahlung, oder mit Korpuskularstrahlung beaufschlagt werden, kann die an der Maske und/oder dem Substrat gebeugte und/oder gebrochene oder reflektierte Strahlung interferieren; beispielsweise können Newtonsche Ringe ausgebildet werden. Derartige Interferenzerscheinungen können auch durch die Welligkeit der Oberfläche von Maske und/oder Substrat beeinflußt oder gefördert werden.

Die vorstehenden, unerwünschten Interferenzerscheinungen oder -muster überlagern als räumlich und/oder zeitlich variable Störgröße das zur Regelung der Ausrichtung von Maske und Substrat herangezogene, erwünschte optische Signal. Diese Störung kann dazu führen, daß die Regelung instabil wird, beispielsweise einem Grenzwert zustrebt, der nicht dem Optimalwert des zur Regelung herangezogenen optischen Signales entspricht, oder Schwingungen, wie aufklingende Schwingungen, durchführt. Ein optimales, exaktes Ausrichten von Maske und Substrat ist dann nicht mehr möglich.

Der Erfindung liegt die Aufgabe zugrunde, ein Verfahren und eine Vorrichtung bereitzustellen, mit denen der Einfluß störender Beugungs- und/oder Interferenzerscheinungen in optischen Systemen, beispielsweise in automatischen Ausrichtvorrichtungen, beseitigt wird.

Diese Aufgabe wird insbesondere mit den Merkmalen der Patentansprüche gelöst.

Zur Lösung der Aufgabe geht die Erfindung von dem Grundgedanken aus, den Einfluß unerwünschter, störender Beugungs-und/oder Interferenzerscheinungen in optischen Systemen dadurch zu verringern oder zu beseitigen, daß die erzeugten Beugungs- und/oder Interferenzmuster "verschmiert" werden. Diese Verschmierung erfolgt erfindungsgemäß insbesondere dadurch, daß die für das Auftreten störender Beugungs- und/oder Interferenzerscheinungen verantwortlichen Bauteile relativ zueinander bewegt werden; diese Bewegung sollte so schnell sein, daß aufgrund der dadurch bewirkten Verschiebung des Beugungs- und/oder Interferenzmusters die totale Intensität der störenden Strahlung während einer für das System charakteristischen Meßzeit an jedem Ort innerhalb des Systems, an dem die Strahlungsintensität gemessen wird, praktisch gleich groß ist. Falls die registrierte Strahlungsintensität beispielsweise als Meßgröße in einem Regelkreis verwendet wird, kann unter charakteristischer Meßzeit etwa die Ansprechzeit oder die Zeitkonstante des Regelkreises verstanden werden. Aufgrund der Verschmierung sollte im zeit-lichen Mittel die Intensität der störenden, gebeugten und/oder gebrochenen Strahlung an jedem Ort der Strahlungsregistrierung etwa gleich groß sein.

Unter "Strahlung" wird erfindungsgemäß elektromagnetische Strahlung, wie sichtbare Strahlung, IR-Strahlung, UV-Strahlung oder Röntgenstrahlung, oder Korpuskularstrahlung, wie Elektronenstrahlen oder Ionenstrahlen, verstanden; entscheidend ist lediglich, daß aufgrund der Wellennatur der Strahlung Beugungs- und/oder Interferenzerscheinungen auftreten können. Dies dürfte insbesondere dann gegeben sein, wenn die verwendete Strahlung im wesentlichen monochromatisch und/oder kohärent ist, ist jedoch nicht auf derartige Strahlung beschränkt.

Die eingangs erläuterte Problematik tritt insbesondere dann auf, wenn innerhalb eines optischen Systems mindestens ein Spalt vorgesehen ist, an dem auftreffende Strahlung gebeugt wird, oder wenn mindestens zwei im wesentlichen plane Flächen eng benachbart und im wesentlichen parallel zueinander angeordnet sind. Im letzteren Fall kann die an den verschiedenen Flächen reflektierte Strahlung miteinander interferieren; diese Interferenzerscheinungen sind mit den bekannten Newtonschen Ringen verwandt. Da in diesem Falle das erzeugte Interferenzmuster vor allem vom Abstand der beiden Bauteile, wie der ebenen Flächen, abhängt, wird bei der Relativbewegung der beiden Bauteile vorzugsweise deren Abstand geändert, um eine möglichst gleichmäßige Verschmierung des Interferenzmusters bereits bei geringfügiger Relativbewegung der beiden Bauteile zu erzielen.

Bei anderen räumlichen Konfigurationen der Bauteile des Systems, beispielsweise wenn die beugenden und/oder brechenden Bauteile nicht plan sind und eine gewisse Welligkeit aufweisen und/oder nicht oder nicht vollständig parallel zueinander sind, kann auch eine Relativbewegung der Bauteile in einer Ebene senkrecht zur Richtung ihres Abstandes eine räumliche Verschmierung des auftretenden Beugungs- und/oder Interferenzmusters bewirken. Selbstverständlich können bei der Relativbewegung der Bauteile auch mehrere Bewegungskomponenten in verschiedenen Richtungen überlagert werden.

Zweckmäßigerweise wird die Relativbewegung der Bauteile derart durchgeführt, daß mindestens eines der Bauteile um eine Gleichgewichtslage vibriert. Da in vielen praktischen Fällen die Streifenbreite des Interferenzmusters unter anderem vom Abstand der beugenden und/oder brechenden Bauteile abhängt, wird diese Schwingungsbewegung vorzugsweise in einer
zur Abstandsrichtung der Bauteile parallelen oder schrägen Richtung durchgeführt, und die Amplitude der Schwingungsbewegung weist mindestens etwa die gleiche Größenordnung wie die Wellenlänge
der verwendeten Strahlung auf. Dadurch soll gewährleistet
werden, daß das Interferenzmuster während der Relativbewegung der Bauteile räumlich um mindestens eine Streifenbreite verschoben wird und dadurch eine möglichst vollständige
Verschmierung des Interferenzmusters eintritt. Dazu ist es
weiterhin zweckmäßig, daß etwa ein Viertel der Schwingungsperiode kürzer ist als die Zeitkonstante bzw. die charakteristische Meßzeit oder Registrierdauer des Systems, wobei
darunter diejenige Zeit zu verstehen ist, während der die
registrierte Strahlung aufintegriert und/oder gemittelt
wird. Vorzugsweise beträgt die charakteristische Meßzeit
ein Vielfaches der Schwingungsperiode; dadurch ist gewährleistet, daß das Interferenzmuster am Ort der Registrierung während dieser charakteristischen Meßzeit derart verschmiert wird, daß praktisch ein räumlich und zeitlich konstantes Störsignal gemessen wird.

Bei in der Praxis verwendeten Systemen, beispielsweise bei
Verfahren zum Ausrichten einer Maske bezüglich eines Substrates, beträgt die Schwingungsamplitude vorzugsweise etwa 1
bis 2 μm bei Verwendung von sichtbarem Licht als Strahlung,
und ist bei Verwendung von Röntgenstrahlung - je nach deren
Wellenlänge - entsprechend kleiner, beispielsweise einige Hundertstel μm. Die Schwingungsfrequenz beträgt vorzugsweise etwa 20 bis 250 Hz, sie kann jedoch ebenfalls in Abhängigkeit
von der Zeitkonstante des verwendeten Systems, beispielsweise
einer automatischen Ausrichtvorrichtung mit einem rückgekoppelten Regelkreis, auch kleiner oder größer sein, z.B. bis zu 20 kHz oder
mehr betragen.

Der Grundgedanke der Erfindung kann bei den verschiedenartigsten optischen Systemen angewendet werden, beispielsweise bei Verfahren und Vorrichtungen zum automatischen Ausrichten einer Fotomaske bezüglich eines Halbleitersubstrates,
wie sie insbesondere zur Herstellung integrierter Schaltungen Verwendung finden. Eine derartige Vorrichtung, bei der
das erfinderische Prinzip vorzugsweise angewandt wird, ist
beispielsweise aus der DE-OS 29 48 646 bekannt.

Bei der bekannten Vorrichtung wird monochromatisches Licht
auf ein Beugungsmuster auf dem Substrat und eine    Teile
des Beugungsmusters gegenüber den von der Lichtquelle kommenden Strahlen abschirmende Richtmarke auf der Maske eingestrahlt, und die an dem Beugungsmuster gebeugten Strahlen
werden in einer aus mehreren Detektoren bestehenden Detektoranordnung registriert. Die relative Intensität der in
verschiedene Richtungen gebeugten Strahlen ist dabei ein Maß
für die Relativstellung von Maske und Substrat in den verschiedenen Translationsrichtungen. Die Ausrichtung der Maske bezüglich des Substrates erfolgt über einen rückgekoppelten Regelkreis, in den die relative Intensität der gebeugten Strahlen als Meßgröße eingeht, wobei der Objekttisch bzw. die Einspannvorrichtung für das Substrat in beiden Translationsrichtungen und in Azimutalrichtung ($\Theta$) schrittweise bewegbar bzw. drehbar ist.

Das Beugungsmuster auf dem Substrat weist vorzugsweise eine
Reihe von Beugungsgittern mit die beiden Translationsrichtungen der Ausrichtbewegung von Maske und Substrat unterscheidenden Merkmalen auf, so daß bei einer konkreten Ausführungsform jeweils die Differenz der Intensität von zwei
in verschiedene Richtungen gebeugten und registrierten
Strahlen als Maß für die Relativverschiebung von Maske
und Substrat in einer bestimmten Translationsrichtung
herangezogen wird. Über den Rückkopplungskreis kann dann
diese Intensitätsdifferenz durch eine Relativbewegung von
Maske und Substrat geregelt und abgeglichen werden. Zur
Regelung sowohl der Translations- als auch der Rotationsbewegung zwischen Maske und Substrat sind bei derartigen Ausrichtvorrichtungen und -verfahren jeweils mindestens zwei Markierungen auf der Maske und dem Substrat erforderlich.

Derartige Vorrichtungen sind bei allen gebräuchlichen Ausricht- oder Justierverfahren im Zusammenhang mit üblichen Belichtungsverfahren, wie Projektions-, Proximity- sowie Vakuum-, Normal- und Weichkontaktbelichtung, anwendbar.

Die Ausrichtung oder Justierung von Maske und Substrat und die nachfolgende Belichtung mit sichtbarer Strahlung, UV-Strahlung, Röntgenstrahlung, Elektronen- oder Ionenstrahlen wird meist bei unterschiedlichem Substrat-Maske-Abstand durchgeführt.

Bei derartigen Vorrichtungen und Verfahren treten insbesondere dann Probleme auf, wenn Maske und Substrat in relativ engen Kontakt gebracht werden, beispielsweise wenn ihr Abstand etwa die Größenordnung der Wellenlänge der verwendeten Strahlung annimmt und/oder wenn die Substrate eine starke Welligkeit aufweisen, beispielsweise ebenfalls in der Größenordnung der Wellenlänge der verwendeten Strahlung. Es können in der Registrierebene neben der erwünschten, an den Beugungsmustern des Substrates gebeugten/Ausricht-Strahlung zusätzliche, durch Überlagerung der an der Maske und am Substrat reflektierten Strahlung hervorgerufene unerwünschte und störende Interferenzerscheinungen beobachtet werden, beispielsweise in Form Newtonscher Interferenzringe, die die erwünschte Strahlung überlagern und den Ausrichtvorgang stören. Die Streifenbreite der Interferenzringe hängt dabei vom Abstand Maske-Substrat und/oder von der Welligkeit von Substrat und Maske ab. Der durch die Störung des Ausrichtvorgangs hervorgerufene Fehler bei der Justierung, beispielsweise 1 bis 2 µm, kann dabei die zulässige Toleranz weit überschreiten.

Erfindungsgemäß werden zur Beseitigung des Einflusses der störenden Strahlung auf den Regel- und Ausrichtvorgang Maske und Substrat relativ zueinander hin- und herbewegt, wobei die Periode dieser Bewegung kürzer ist als die Regelzeit der Ausrichtbewegung, die in Abhängigkeit von der registrierten Strahlungsintensität erfolgt. Unter "Regelzeit" der Ausrichtbewegung ist dabei die für das Nachlaufverhalten der automatischen Justierung charakteristische Zeitkonstante zu verstehen; die Periode der der Ausrichtbewegung überlagerten Relativbewegung soll insbesondere so kurz sein, daß die Störstrahlung lediglich einen räumlich und zeitlich verschmierten Untergrund für die zur Regelung der Ausrichtung herangezogene, am Beugungsmuster des Substrates gebeugte Strahlung ausbildet. Dies kann vorzugsweise dadurch erreicht werden, daß bei der periodischen Relativbewegung von Maske und Substrat deren Abstand variiert wird, da die räumliche Ausbildung des störenden Interferenzmusters direkt vom Abstand Maske-Substrat abhängt, die Intensität der am Beugungsmuster des Substrates gebeugten und registrierten Strahlung jedoch in erster Näherung von diesem Abstand unabhängig ist./wird das unerwünschte Interferenzmuster dem zur Ausrichtung herangezogenen Extremum der erwünschten, gebeugten Strahlung lediglich als verschmierter, bei der Bestimmung des Extremums nicht störender Untergrund überlagert.

Je nach Ausbildung von Maske und Substrat kann die angestrebte Verschmierung auch dadurch verbessert werden, daß die periodische Relativbewegung von Maske und Substrat eine Bewegungskomponente parallel zur Ebene von Maske und/oder Substrat, d. h. zur Ebene der Ausrichtbewegung, aufweist.

Vorzugsweise sind die Maske und das Substrat im wesentlichen plan und zueinander parallel, wobei es vorteilhaft ist, die periodische Relativbewegung etwa senkrecht zur Ebene von Maske und Substrat auszuführen.

Im übrigen sind die vorstehend erläuterten allgemeinen Prinzipien des erfindungsgemäßen Verfahrens sowie dessen bevorzugte Ausgestaltungen bei der Anwendung des Erfindungsgedankens bei automatischen Ausrichtverfahren ebenfalls gültig.

Die erfindungsgemäße Ausrichtvorrichtung, die grundsätzlich beispielsweise wie in der DE-OS 29 48 646 beschrieben ausgebildet ist, zeichnet sich insbesondere durch Einrichtungen aus, mit denen eine periodische Relativbewegung der auszurichtenden Bauteile durchgeführt werden kann. Mit der erfindungsgemäßen Vorrichtung läßt sich das erfindungsgemäße Verfahrensprinzip, störende Beugungs- und/oder Interferenzerscheinungen in einem optischen System räumlich und/oder zeitlich zu verschmieren oder auszumitteln, realisieren.

Vorzugsweise wird bei der Relativbewegung der Bauteile deren Abstand variiert und/oder die periodische Relativbewegung erfolgt im wesentlichen in einer Ebene senkrecht zur Abstandsrichtung der beiden Bauteile.

Bei einer bevorzugten Ausführungsform wird die periodische Relativbewegung dadurch erzeugt, daß die Stellvorrichtung der Einspannvorrichtung des Substrates rasch hin- und herbewegt wird, beispielsweise mittels der Schrittmotoren, die zur Durchführung einer Abstandsänderung zwischen Maske und Substrat, wie sie beispielsweise zwischen Justierung und Belichtung erfolgen kann, vorgesehen sind.

Es können auch zusätzliche Einrichtungen vorgesehen sein, beispielsweise mehrere auf der Einspannvorrichtung angeordnete mechanische Vibratoren, durch die die Einspannvorrichtung mit dem Substrat in rasche Schwingung versetzt wird. Wenn als Maske dünne Folien von beispielsweise einigen µm Dicke verwendet werden, wie dies beispielsweise bei der Röntgen-

strahllithographie vorgesehen ist, kann die Maske auch durch Schallgeber in Schwingung (z.B. 20 kHz) versetzt und auf diese Weise relativ zum Substrat bewegt werden.

Bevorzugt ist, daß die Maske und/oder das Substrat entspiegelt sind und/oder eine Lackschicht aufweisen.

Die Erfindung wird nachstehend anhand der Zeichnung näher erläutert. Es zeigen:

Fig. 1 eine erfindungsgemäße Maskenjustiervorrichtung in schematischer Form und

Fig. 2 einen zur Erläuterung der auftretenden Interferenzerscheinungen herangezogenen Ausschnitt von Fig. 1.

Bei der dargestellten Maskenjustiervorrichtung wird Strahlung einer im wesentlichen monochromatischen Quelle, z.B. eines Lasers 1, durch einen Chopper 2 zerhackt und in einem Teilerprisma 3 in zwei Teilstrahlenbündel aufgeteilt, die mittels zweier Umlenkprismen 4a, b durch Öffnungen 5a, b eines Schirms 6 und durch Blenden 7a, b auf jeweils zwei entfernte Bereiche der Maske 8 und des Substrates 9 gerichtet werden. Auf den von den beiden Teilstrahlenbündeln getroffenen Bereiche der Maske 8 und des Substrats 9 sind jeweils Richtmarken 10a, b bzw. Beugungsmuster 11a, b derart angeordnet, daß die Intensität der an den Beugungsmustern 11a, b gebeugten und von den einzelnen Sonden einer Detektoranordnung 12 registrierten Strahlung von der relativen Orientierung von Maske 8 und Substrat 9 abhängt. Die Richtmarken 10a, b und die Beugungsmuster 11a, b sind vorzugsweise wie in der DE-OS 29 48 646 beschrieben ausgebildet. Die relative Intensität der von jeweils mindestens zwei Sonden der Detektoranordnung 12 registrierten Strahlung wird als Meßgröße für die relative Verschiebung der Maske 8 bezüglich des Substrates 9 in einer der Translationsrichtungen X und Y herangezogen. Diese Meßgröße wird mit einem Sollwert oder Referenzwert verglichen, und entsprechend der Regelabweichung werden die Stellvorrichtungen 15 der Einspannvorrichtung 14 des Substrates 9 betätigt. Die Einspannvorrichtung 14 ist beispielsweise ein X- Y- Z- θ-Tisch, der durch Stellmotoren angetrieben wird. Die Regelung erfolgt solange, bis die Meßgröße auf den gewünschten Referenzwert eingeregelt ist. Der Referenzwert kann dabei entweder durch eine vorherige Justierung von Hand vorgegeben oder während des Justiervorganges, beispielsweise als Extremalwert, ermittelt werden. Bei der Ausrichtbewegung in der X-Y-Ebene können entweder die Maske 8 oder das Substrat 9 oder Maske 8 und Substrat 9 bewegt werden.

Bei der vorstehend erläuterten Ausrichtbewegung sind Maske 8 und Substrat 9 parallel zueinander und eng benachbart im Abstand d angeordnet. d beträgt beispielsweise einige μm.

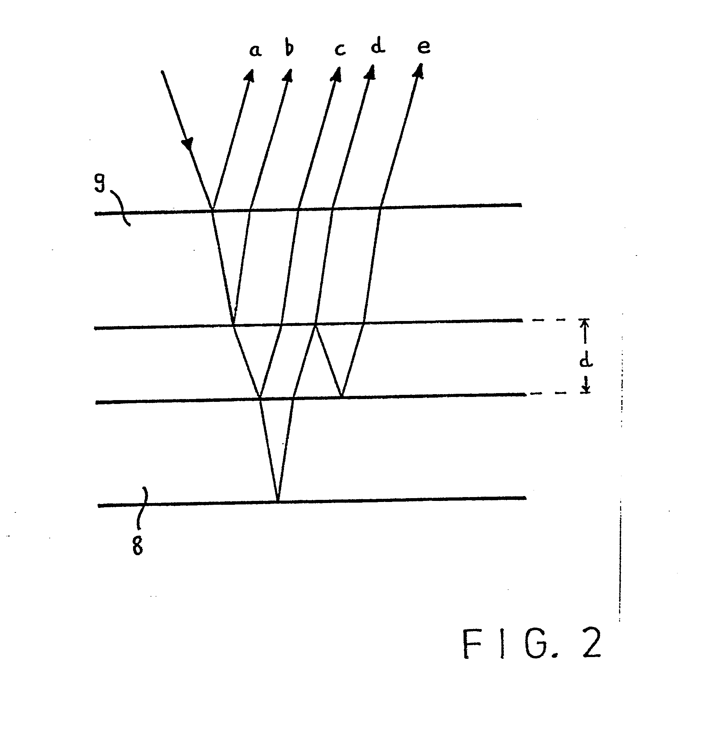

Fig. 2 erläutert schematisch die an den verschiedenen Grenzflächen auftretende Brechung und/oder Reflexion und die daraus resultierenden Interferenzerscheinungen; zur Vereinfachung sind die Richtmarken 10a, b und die Beugungsmuster 11a,b in Fig. 2 nicht eingezeichnet. Der Einfallswinkel der von der Quelle 1 kommenden auftreffenden Strahlung ist zur Verdeutlichung übertrieben eingezeichnet; tatsächlich trifft die Strahlung nahezu senkrecht auf die Maske 8 auf.

In Fig. 2 sind beispielhaft mehrere, an verschiedenen Grenzflächen von Maske 8 und Substrat 9 gebrochene und/oder reflektierte Teilstrahlen a-e eingezeichnet. Diese Teilstrahlen treten parallel aus der Maske 8 aus und interferieren miteinander, wobei je nach Gangunterschied bzw. Phasenbeziehung der einzelnen Teilstrahlen eine Auslöschung oder Verstärkung der Strahlung eintritt. Die auftretenden Interferenzerscheinungen hängen somit stark vom Abstand d von Maske 8 und Substrat 9 ab.

Die reflektierten Teilstrahlen a-e werden ebenfalls von der Detektoranordnung 12 registriert; die erläuterten Interferenzerscheinungen überlagern dabei die zur Ausrichtbewegung herangezogene, gewünschte Strahlung und stören die Ausrichtung.

Um die vorstehend erläuterten, störenden Interferenzerscheinungen zu verschmieren oder auszumitteln, sind bei der in Figur 1 dargestellten, erfindungsgemäßen Ausrichtvorrichtung Einrichtungen vorgesehen, mit denen die Maske 8 und das Substrat 9 relativ zueinander schnell und periodisch bewegt werden können; vorzugsweise wird bei dieser Bewegung der Abstand d von Maske 8 und Substrat 9 periodisch variiert, die Bewegung kann jedoch auch eine Komponente in der X-Y-Ebene aufweisen. Zur Erzeugung des relativen "Wackelns" von Maske 8 und Substrat 9 sind verschiedene Maßnahmen vorgesehen, die alternativ oder gleichzeitig durchgeführt werden können.

Beispielsweise kann der Maskenhalter 13 mit der Maske 8 in Schwingung versetzt werden, die Schwingung kann aber vorzugsweise auch auf die Einspannvorrichtung 14 des Substrates 9 übertragen werden. In diesem Fall ist es besonders zweckmäßig, daß die Schwingungsbewegung direkt über die Stellvorrichtung 15 der Einspannvorrichtung 14 zugeführt wird, die zur Durchführung einer Abstandsänderung zwischen Maske 8 und Substrat 9, beispielsweise zwischen Ausrichtung und Belichtung des Substrats, in Z-Richtung beweglich ist. Zweckmäßigerweise erfolgt die Bewegung in Z-Richtung, wie in den übrigen Translationsrichtungen, durch Stell- oder Schrittmotoren, mit denen auf einfache Weise eine Schwingungsbewegung durchgeführt werden kann.

Es können zur Anregung einer Schwingungsbewegung auch zusätzliche Maßnahmen vorgesehen sein; beispielsweise können - wie in der Zeichnung dargestellt - vorzugsweise mehrere Vibratoren 16 auf der Einspannvorrichtung (chuck) 14 des Substrats 9 oder auf dem Maskenhalter 13 vorgesehen sein. Bei Anwendung üblicher lichtoptischer oder UV-Lithographieverfahren wird die Schwingungsbewegung zwischen Maske 8 und Substrat 9 vorzugsweise mit einer Frequenz von etwa 20 bis 250 Hz und einer Amplitude von etwa 1 bis 2 μm durchgeführt. Die Interferenzunterdrückung läßt sich dadurch weiter verbessern, daß die Maske 8 und/oder das Substrat 9, beispielsweise durch eine Lackschicht, entspiegelt sind.

Bei der Anwendung von Röntgenlithographieverfahren, bei denen vorzugsweise piezoelektrische Tische und als Masken-Folien mit einer Dicke von etwa 10 μm verwendet werden, kann die Vibration auch durch Schallwellen hervorgerufen werden. Die Schallwellen werden vorzugsweise von einem bei der Maske angeordneten Schallgeber oder Lautsprecher erzeugt, dessen ebene Wellenfront z.B. etwa parallel zur Maskenfläche ist, d.h. die Lautsprecherachse ist etwa senkrecht zur Maskenebene.

Eine weitere Erhöhung der Genauigkeit der Ausrichtung läßt sich/dadurch erfindungsgemäß erreichen, daß eventuelle Inhomogenitäten der Strahlungsintensität im Querschnitt der zur Ausrichtung verwendeten Strahlung, beispielsweise eines Lasers, dadurch ausgeglichen werden, daß mit dem Laserstrahl eine Scan-Bewegung über die Ausrichtmarken hinweg durchgeführt wird. Dadurch werden die Strahlinhomogenitäten über die gesamte Fläche der Markierungen, wie der Richtmarken 10a, b und der Beugungsmuster 11a, b , "verschmiert".

Die Durchführung des Scannens kann dabei auf verschiedene daß Weise erfolgen; entscheidend ist,/im zeitlichen Mittel eine homogene Verteilung der Intensität über den Strahlquerschnitt erzielt wird und somit jede Flächeneinheit des Beugungsmusters im zeitlichen Mittel von der selben Strahlungsmenge getroffen wird.

Das Scannen sollte allerdings, wie vorstehend anhand der Verschmierung störender Interferenzerscheinungen erläutert, so rasch erfolgen, daß ein kompletter Scan-Zyklus kürzer ist als die "Regelzeit" oder die Zeitkonstante der Ausrichtbewegung.

## Patentansprüche


1.  Verfahren zum Unterdrücken unerwünschter Beugungs-
    und/oder Interferenzerscheinungen in Systemen, in
    denen mindestens zwei benachbarte, auftreffende Strahlung beugende und/oder brechende Bauteile (8, 9) mit
    im wesentlichen monochromatischer elektromagnetischer
    Strahlung oder Korpuskularstrahlung bestrahlt werden
    und die Intensität der von den Bauteilen (8, 9) kommenden Strahlung an mindestens einem Ort des Systems registriert wird, wobei an diesem Ort neben der erwünschten Nutzstrahlung, beispielsweise die als Information
    über die gegenseitige Ausrichtung der Bauteile (8, 9)
    dienende Strahlungsverteilung, auch unerwünschte, von
    Beugungs- und/oder Interferenzerscheinungen im System
    herrührende Störstrahlung auftritt,
    d a d u r c h   g e k e n n z e i c h n e t,  daß die
    Bauteile (8, 9) während des Meßintervalls für die Nutzstrahlung relativ zueinander bewegt werden, so daß der
    Mittelwert der mitgemessenen Störstrahlung in jedem
    Meßintervall gleich groß ist.


2.  Verfahren nach Anspruch 1, dadurch gekennzeichnet, daß
    die Bauteile (8, 9) jeweils eine im wesentlichen plane
    Fläche aufweisen, wie eine Maske (8) und ein Substrat
    (9), und die Flächen zueinander parallel sind.


3.  Verfahren nach Anspruch 1 oder 2, dadurch gekennzeichnet, daß der Abstand der Bauteile (8, 9) während der
    Registrierdauer variiert wird.


4.  Verfahren nach einem der Ansprüche 1 bis 3, dadurch gekennzeichnet, daß die Relativbewegung der Bauteile (8, 9) eine
    Komponente in einer Ebene senkrecht zur Abstandsrichtung aufweist.

5. Verfahren zum gegenseitigen Ausrichten einer Maske (8) und eines Substrates (9), insbesondere zur Herstellung integrierter Schaltungen, wobei im wesentlichen monochromatische Strahlung von mindestens einer Strahlungsquelle (1) an der Maske (8) und/oder dem Substrat (9) gebeugt und/oder

gebrochen wird, die gebeugte und/oder gebrochene Strahlung in einer Detektoranordnung (12) registriert wird und die Relativbewegung zum Ausrichten von Maske (8) und Substrat (9) in Abhängigkeit von der registrierten Strahlungsintensität geregelt wird,
dadurch gekennzeichnet, daß der Ausrichtbewegung eine periodische Relativbewegung von Maske (8) und Substrat (9) überlagert wird, deren Periode kürzer ist als die Regelzeit der in Abhängigkeit von der registrierten Strahlungsintensität erfolgenden Ausrichtbewegung.


6. Vorrichtung zum Ausrichten von mindestens zwei Bauteilen (8, 9), an denen auftreffende Strahlung gebeugt und/oder gebrochen werden kann, insbesondere mit einem Verfahren nach einem der Ansprüche 1 bis 5, mit

(a) einer im wesentlichen monochromatischen Strahlungsquelle (1),

(b) einer Detektoranordnung (12) zum Registrieren der an den Bauteilen (8, 9) gebeugten und/oder gebrochenen Strahlung,

(c) einer Regel- und Stellvorrichtung (15) zum Ausrichten der beiden Bauteile (8 , 9) in Abhängigkeit von der von der Detektoranordnung (12) registrierten Strahlung,
gekennzeichnet durch

(d) Einrichtungen (13-16) zum Durchführen einer periodischen Relativbewegung der Bauteile (8, 9) während der Strahlungsregistrierung, durch die unerwünschte Beugungs- und/oder Interferenserscheinungen räumlich und/oder zeitlich ausgemittelt werden.

7. Vorrichtung nach Anspruch 6, dadurch gekennzeichnet, daß die auszurichtenden Bauteile

   (a) eine im wesentlichen plane Maske (8) mit mindestens einer Richtmarke (10a, b) und

   (b) ein im wesentlichen planes Substrat (9) mit mindestens einem Beugungsmuster (11a, b) aufweisen.

8. Vorrichtung nach Anspruch 7, dadurch gekennzeichnet, daß die Einspannvorrichtung (14) des Substrats (9) in Schwingung versetzt wird.

9. Vorrichtung nach einem der Ansprüche 7 oder 8, dadurch gekennzeichnet, daß die periodische Relativbewegung über die Stellvorrichtung (15) der Einspannvorrichtung (14) des Substrats (9) angeregt wird.

10. Vorrichtung nach einem der Ansprüche 7 bis 9, dadurch gekennzeichnet, daß die Maske (8) und /oder der Maskenhalter (13) in Schwingung versetzt werden.

FIG. 1

0091106

F I G. 2

**0091106**
Nummer der Anmeldung

Europäisches
Patentamt

**EUROPÄISCHER RECHERCHENBERICHT**

EP  83 10 3239

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | US-A-3 615 449  (D.L. GREENAWAY) <br> * Spalte 5, Zeilen 5-75 * | 1 | G 03 B  41/00 |
| A | * Spalte 5, Zeilen 5-75 * | 2-10 | |
| Y | US-A-4 132 479  (G. DUBROEUCQ et al.) <br> * Spalte 4, Zeilen 37-63 * | 1 | |
| A | DE-A-2 755 047  (THOMSON-CSF) <br> * Seite 14, Zeile 17 - Seite 15, Zeile 18 * | 1 | |
| A | EP-A-0 025 397  (THOMSON-CSF) <br> * Seite 10, Zeilen 7-21 * | 1 | RECHERCHIERTE SACHGEBIETE (Int. Cl. ³) |
| A | US-A-4 265 542  (K.A. SNOW) <br> * Zusammenfassung * | 1 | G 01 B  11/00 <br> G 03 B  41/00 <br> G 03 F  9/00 <br> G 05 D  3/00 |
| A,D | DE-A-2 948 646  (RCA CORP.) | 1,5,6 | H 01 J  37/00 |
| A | MESSEN + PRÜFEN/AUTOMATIK, Oktober 1979, Seiten 767,768,771, Bad Wörishofen, DE. H.        SCHAUMBURG: "Lithografietechniken     für höchstintegrierte Schaltungen" * Kapitel 3, erster und letzter Absatz * | | |

Der vorliegende Recherchenbericht wurde für alle Patentansprüche erstellt.

| Recherchenort <br> DEN HAAG | Abschlußdatum der Recherche <br> 07-07-1983 | Prüfer <br> PRATSCH H.R. |
|---|---|---|